Europäisches Patentamt

European Patent Office

Office européen des brevets

(19)

(11) Publication number: **0 148 209**
**B1**

## (12) EUROPEAN PATENT SPECIFICATION

(45) Date of publication of patent specification: **02.11.88**

(51) Int. Cl.⁴: **C 23 C 18/28**

(21) Application number: **84902283.5**

(22) Date of filing: **21.05.84**

(86) International application number:
**PCT/US84/00779**

(87) International publication number:
**WO 85/00387 31.01.85 Gazette 85/03**

(54) **OXIDIZING ACCELERATOR.**

(30) Priority: **01.07.83 US 510333**

(43) Date of publication of application:
**17.07.85 Bulletin 85/29**

(45) Publication of the grant of the patent:
**02.11.88 Bulletin 88/44**

(84) Designated Contracting States:
**BE CH DE FR GB LI NL SE**

(56) References cited:
**US-A-3 011 920**
**US-A-3 513 015**
**US-A-3 533 828**
**US-A-3 562 038**
**US-A-4 448 811**

(73) Proprietor: **MACDERMID, INCORPORATED**
**50 Brookside Road**
**Waterbury, CT 06708 (US)**

(72) Inventor: **KUKANSKIS, Peter, E.**
**245 Quassapaug Rd.**
**Woodbury, CT 06798 (US)**
Inventor: **GRUNWALD, John, J.**
**161 Whittier Rd.**
**New Haven, CT 06515 (US)**
Inventor: **SAWOSKA, David**
**74 Woodhaven Street**
**Waterbury, CT 06708 (US)**

(74) Representative: **Warren, Keith Stanley et al**
**BARON & WARREN 18 South End Kensington**
**London W8 5BU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# 0 148 209

**Description**

The present invention relates to improving electroless deposition on a non-conductive substrate by increasing the catalytic activity of the catalyst on the substrate prior to electroless plating. More particularly, the present invention relates to an improvement in a method of electroless plating wherein a non-conductive substrate is treated with a catalyst and the catalyst treated substrate is then contacted with an accelerator bath which increases the catalytic activity of the catalyzed substrate.

The method of the present invention is applicable in functional applications where metal deposited on a non-conductive substrate renders the substrate thermally conductive, electrically conductive, stronger, or more rigid, or a combination of these properties. The method of the present invention may also be used in decorative applications where the substrate is plated with a metal deposit to provide a pleasing finish.

Metals are deposited on non-conductive substrates by electroless plating techniques by first rendering the surface of the non-conductive substrate catalytic toward electroless metal deposition. In prior art methods, non-conductive substrates are cleaned, etched or made catalyst. The commercially predominant electroless systems typically deposit copper or nickel wherein the metal plating baths commonly contain reducing agents, usually formaldehyde in alkaline solution for copper plating, and more recently, hypophosphite reduced baths for copper plating, and hypophosphite reduction for nickel metal. When catalyzed non-conductive substrates are immersed or brought in contact with the electroless metal baths, a metal film will result on the substrate.

Widely accepted catalyst solutions are the tin-palladium colloids such as described in U.S. Patent 3,011,920 and U.S. Patent 3,532,518. They are composed of acidic solutions of tin-palladium which are made colloidal upon aging and/or heating, or by other known suitable methods. In these tin-palladium activator sols, the palladium is the catalytically active material, and the tin acts as a protective colloid, stabilizing the bath. When the non-conductors are immersed in these tin-palladium colloid activator baths, the active catalyst absorbs or adheres to the non-conductive substrate.

However, the presence of the protective tin can cause problems in the electroless metal deposition step, such as lengthy metal deposition times, blistering of deposited metal to substrate and contamination of the bath with tin. Therefore, an acceleration step is added between the activation step and electroless metal deposition. The prior art accelerator bath comprises a solvent for the protective metal, being substantially a non-solvent for the catalytic metal. The result of immersion of the substrate in the accelerator bath is exposure of the catalytic surface for electroless deposition. The accelerator step is followed by water rinsing to avoid or reduce contamination of the plating bath with accelerator solution.

The "accelerator" solution used to "accelerate" the catalyzed non-conductor as described in U.S. Patent 3,011,920 is an acidic or alkaline solution which is thought to act as "a solvent to remove the protective colloid and/or the deflocculating agent from the colloidal particles of catalytic metal on the substrate surface". This patent further discloses that oxidation of the treated surface should be avoided. As described in U.S. Patent 3,011,920 the "accelerator" step may sometimes be omitted when using an electroless bath solution that will itself be effective to remove the stabilizing material (such as an alkaline electroless copper bath using formaldehyde reducing agent.)

In certain hypophosphite reduced nickel baths, and in some more recently developed hypophosphite reduced copper baths as described in U.S. Patent Nos. 4,209,331 and 4,279,948, insufficient coverage of electroless metal on catalyzed substrates may occur if the accelerator step is omitted. Using the standard prior art acid or alkaline accelerators with these hypophosphite baths produced coverage but problems with slow rates of metal deposition were encountered. In general it can be said that when using the commercially proven, well stabilized electroless solutions, one finds the proper "acceleration" of the substrate to be a necessary step to insure complete coverage of metal on the catalyzed surface. However, problems can be encountered with the acceleration step itself. So-called "over-acceleration" which is thought to be excessive removal of catalytic metal from the substrate, can cause skip plating or "voiding" of the electroless metal film. Since inherent surface conditions of the various non-conductor substrates cause varying amounts of catalyst adsorption over the surface of a given part, one area of the part can be over accelerated (that is, too much catalyst is removed), thus causing skip plating, whereas another area of the same part which has a more adequate catalyst adsorption due to more favorable surface topography could be properly accelerated and acceptably plated. Thus for the variety of parts plated commercially, one will inevitably obtain varying degree of catalyst adsorption, thus narrowing and complicating the accelerator solution parameters that must be maintained to insure that, over a given part, areas low in catalyst density not get over accelerated, while avoiding the problem that more effectively catalyzed areas of the part be "under accelerated". With conventional acceleration baths, rinses following the acceleration step may become contaminated, or the electroless plating bath may become contaminated by stannous tin and operate outside desired optimum parameters. In production situations, such instances are common rather than exceptional.

US—A—3562038 discloses a process wherein selected areas of a substrate are catalysed, after mechanical abrasion by the application of a colloidal palladium/stannic acid catalyst and that contacted with an acidic stripping solution comprising for example ferric chloride or sodium perborate to remove colloidal components from those parts of the surface which have not been abraded.

2

US—A—3513015 discloses a process wherein after treatment with the Sn/Pd catalyst the substrate is immersed in a hydrogen peroxide solution prior to plating.

The method of the present invention is characterised in that the accelerator bath comprises an alkaline solution of an oxidising agent which oxides the tin from $Sn^{+2}$ to $Sn^{+4}$.

It is possible by means of the invention to provide improved accelerator compositions for use in a method of electroless plating that will produce a superior catalytic surface on a non-conductive substrate which is to be electrolessly plated, thereby providing more complete and rapid coverage on non-conductive substrates in the electroless plating bath. The oxidation of the tin component helps to eliminate or reduce contamination of rinses and the plating bath with stannous tin ($Sn^{+2}$).

A particularly preferred tin-palladium catalyst solution for use in the electroless deposition of copper is disclosed in U.S. Patent 3,532,518.

The accelerator bath contains an oxidizing agent for the tin. Although it has been found that an aqueous bath comprising sodium chlorite is an excellent accelerator bath for a tin-palladium catalyst solution, other agents which oxidize tin may be used in the bath, and such agents include, for example, sodium dichloroisocyanurate, sodium hypochlorite, sodium chlorate, potassium permanganate, sodium perborate and compatible mixtures thereof.

In a method wherein copper is to be electrolessly deposited, the hypophosphite reduced copper baths and method disclosed in U.S. Patent Nos. 4,209,331 and 4,279,948 can be used. Other commercially available electroless deposition baths may be used. For example, for the deposition of copper, conventional formaldehyde reduced copper baths may be used. It has also been determined that electroless nickel baths may be used with a tin-palladium catalyst solution and an accelerator bath in accordance with the present invention.

The type of substrate upon which metal is to be deposited will vary depending upon the desired end use. For example, often it is desired to manufacture a printed circuit board by the deposition of copper on a non-conductive/conductive laminate. Also, it is known to deposit metal on a plastic substrate.

It is believed that the oxidizing accelerator of the present invention oxidizes (stannous) $Sn^{+2}$ to (stannic) $Sn^{+4}$ with the possible hydrolysis of a $Sn^{+4}$ compound which renders the adsorbed palladium catalyst material more catalytically active towards the electroless metal reduction mechanism providing increased plating rates. The $Sn^{+4}$ is also believed to be less harmful to the plating bath and rinses than $Sn^{+2}$. Thus, any oxidized tin carried into the plating bath will have less effect on the plating bath than $Sn^{+2}$, and the plating bath will last longer and plate better over its life.

A preferred embodiment of this invention comprises the use of copper-clad laminates with thru-holes as substrates to be electrolessly plated although plastics and other non-conductive substrates can be used. The substrates are first cleaned with suitable cleaners known to the art, followed by appropriate rinses. These cleaners can also contain "conditioning" agents which promote the adhesion of catalytic material to the substrate. The substrate is then usually etched with a chemical etchant, several of which are commercially available for this purpose, in order to prepare the copper portion of the surface for reception of the activator and subsequent electroless plating. Acid dips, neutralizers, and water rinses may be included before and after etching if applicable. The substrate is then contacted with an activator which is a standard proprietary catalyzing agent such as the tin-palladium sol described in U.S. Patent No. 3,532,518.

The treated substrate, after the catalyst solution has been applied thereto, is rinsed and then contacted with an accelerator bath in accordance with the present invention. The accelerator bath contains one or more oxidizing agents in a sufficient quantity for the oxidizing agent to oxidize the tin and increase the catalytic activity of the palladium. For the previously described tin-palladium catalyst solution, it has been found that the preferred oxidizing agent is sodium chlorite, although other oxidizing agents such as sodium dichloroisocyanurate, sodium hypochlorite, sodium chlorate, potassium permanganate, and mixtures of these oxidizing agents can be used.

Although the concentration of the oxidizing agent in the accelerator bath will vary depending upon variables such as the temperature and time of application of contact in the accelerator bath, it is believed a concentration of oxidizing agent in the accelerator bath should be sufficient to oxidize the protective stannous ions on the substrate. Preferably, the accelerator bath contains from about 1 gram per liter of oxidizing agent to saturation. The accelerator bath may include additional components, such as a buffer, and an acid or base to adjust the pH of the accelerator bath to the desired pH. The buffer selected should be compatible with the oxidizing agent used, and it has been found that when sodium chlorite is used as the oxidizing agent, sodium bicarbonate is a suitable buffer.

One particularly preferred accelerator bath of this invention comprises 5 g./l. sodium chlorite and 10 g./l. sodium bicarbonate. The pH is adjusted to 8.3 with acid or base on make-up if necessary. The substrates are subjected to the bath for 5 minutes at a temperature of 60°C (140°F). Temperatures of the bath may vary from about room temperature to about 60°C (140°F). Higher temperatures can be used. However, no improvement is believed to be gained at temperatures over 60°C (140°F). Preferably time in the accelerator bath ranges from about 2 to 6 minutes. These times are typically used for production purposes. However, these times may vary out of this range depending on the temperature and concentration of the bath. The time used is actually the time necessary to provide the best metal coverage and rates of metal deposition within these variables of temperature and concentrations.

Sodium bicarbonate is only used as a buffer and may be used in any amounts sufficient to maintain pH in a range of about 8.3, to 9.5. The pH may vary from this somewhat provided it is maintained in the alkaline range.

Once the substrate has been treated with the accelerator bath, the substrate is then rinsed with water and subjected to an electroless deposition bath. In the instance where it is desired to plate the substrate with copper, a hypophosphite reduced copper bath and method as disclosed in U.S. Patent No. 4,209,331 and 4,279,948 may be used.

The advantages of a method in accordance with the present invention in which an accelerator bath including an oxidizing agent are shown in the following examples:

Example 1

Epoxy glass laminate panels (FR-4) which are commercially available are used as the substrate. This epoxy glass is commonly used for printed circuit boards which are typically copper-clad with drilled through-holes. These panels are also used to check the amount of metal deposited in a time period in an electroless deposition bath, in this example, a hypophosphite reduced copper bath. The rate of deposition is expressed in microinches of copper for the time period used. These panels are first stripped of the copper-cladding foil, rinsed, dried and weighed and then catalyzed by the "one-step" method using a commercially available mixed palladium-tin catalyst as disclosed in U.S. Patent 3,532,518, along with its method of use. This commercially available solution is sold by MacDermid Incorporated under the designation Mactivate 10 and contains hydrochloric acid, palladium metal and stannous ion from stannous salts.

The panels are rinsed and contacted with the accelerator bath of this invention comprising 5 g./l. sodium chlorite and 10 g./l. sodium bicarbonate in water for 5 minutes at 60°C (140°F). The pH of the bath is 8.3.

The substrate is then rinsed and electrolessly plated in a hypophosphite reduced copper bath as disclosed in U.S. Patent Nos. 4,209,331 and 4,279,948 along with its method of use for 6 minutes. The plating bath had the following composition:

$CuCl_2 \cdot 2H_2O$: 0.06M (10 g./l.)
N-hydroxyethyl ethylenediamine triacetic acid: (0.074M (26 g./l.))
$NaH_2PO_2$—$H_2O$: 0.34 M (26 g./l.)
Water
pH adjuster as needed for pH 9 (HCl or NaOH)
Bath temperature: 60—65°C (140°—150°F).

The panels were removed from the bath and examined and copper coverage was found to be good. The panels were weighed, stripped of deposited copper and weighed again. The rate of copper deposited was determined to be 20.1 microinches (510.5 nm) in 6 minutes deposition time.

Examples 2—9

FR-4 epoxy glass rate panels are subjected to the procedure of Example 1. Varying concentrations of sodium chlorite are used. The results are shown in Table A.

TABLE A

| Example No. | NaClO₂ g./l. | Accelerator | | | | Electroless deposition | |
|---|---|---|---|---|---|---|---|
| | | NaHCO₃ g./l. | pH | Temp. °C | Time in accelerator (min.) | Plating time (min.) | Deposition thickness microinches Cu (nm) |
| 2 | 1.0 | 10 | 8.3 | 60 | 5 | 6 | 16.80 (426.7) |
| 3 | 5.0 | 10 | 9 | 60 | 2 | 6 | 20.50 (520.7) |
| 4 | 20.0 | 10 | 8.5 | 60 | 5 | 6 | 16.42 (417.1) |
| 5 | 25.0 | 10 | 8.6 | 60 | 5 | 6 | 15.70 (398.8) |
| 6 | 26.5 | 10 | 9.5 | 60 | 5 | 6 | 18.00 (457.2) |
| 7 | 53.0 | 10 | 8.8 | 60 | 5 | 6 | 15.70 (398.8) |
| 8 | 5.0 | 10 | 8.3 | 60 | 5 | 10 | 34.00 (863.6) |

Examples 2—8 substrates had good copper coverage and good pink color after electroless deposition. Example 9 with NaHCO₃ and no NaClO₂ provides much slower plating rates than Examples 2—8.

4

## Example 10

Panels of ABS plastic were subjected to a chromic acid etchant followed by a neutralizer and water rinse. This treatment is typical for preparation of ABS plastic prior to activation for reception of electroless plating. The panels were then subjected to the activator and accelerator according to the procedure of Example 1. Good copper coverage and color are seen after electroless deposition along with favorable plating rates.

## Example 11

The procedure of Example 1 is followed except that the accelerator bath contained 5 g./l. of potassium dichloroisocyanurate as the oxidizer and 10 g./l. of $NaHCO_3$ as a buffer. The pH was 8.5 and the panels were treated with the accelerator bath for 5 minutes at 60°C (140°F). The panels were then rinsed and immersed in the hypophosphite reduced electroless copper bath for 6 minutes. The rate was 17.8 microinches (452.1 nm) of copper in 6 minutes plating time. Copper coverage and color were good.

## Examples 12—16

Accelerator baths are prepared containing a variety of oxidizers. The procedure of Example 1 is followed with the following concentrations of oxidizers:

Example 12: sodium chlorate 25 g./l.
Example 13: potassium permanganate 1 g./l.
Example 14: sodium perborate 5 g./l.
Example 15: sodium hypochlorite 5 g./l.
Example 15 also contains 10 g./l. $NaHCO_3$ to maintain the pH in an alkaline range.
The panels all showed good copper coverage, color and rates of copper deposition.

## Example 16

The procedure of Example 1 is followed except that after acceleration and rinsing, the panels were immersed in a commercially available formaldehyde reduced electroless copper bath sold by MacDermid Incorporated under the designation MACu Dep 20 containing copper salts, formaldehyde, sodium hydroxide and complexers.

Good copper coverage and plating rates were obtained with this copper bath and the accelerator bath of this invention.

## Example 17

ABS plastic panels are subjected to a typical ABS electroless deposition system using the "one-step" activator of Example 1, rinsed, and subjected to the accelerator of this invention according to the procedure of Example 1. The panels were rinsed and immersed in a commercially available hypophosphite reduced electroless nickel bath sold by MacDermid Incorporated under the designation MACuplex 9340. The bath contained the following components: Nickel salts, hypophosphite, buffering agents, stabilizers and complexers.

Good nickel coverage and plating rates were obtained with this nickel bath, plastic substrates and the accelerator bath of this invention.

## Comparative Example A

FR-4 epoxy glass laminate panels were subjected to the procedure of Example 1 except that a known prior art aqueous sulfuric acid accelerator such as that disclosed in U.S. Patent 3,011,920, containing 56% by weight of $H_2SO_4$ was used instead of the accelerator of this invention. Electroless deposition time was again 6 minutes. 12.2 microinches (309.9 nm) of copper was deposited in 6 minutes. However, the plated panels were darker and transparent in some areas when compared to those of Example 1, showing insufficient and uneven metal coverage.

## Comparative Example B

The procedure of Example 1 is followed except that an accelerator bath containing a reducing agent, 1% hydrazine in water, was used instead of the accelerator bath of this invention. A reducing agent was used to test the concept that it is the oxidizer of this invention that provides improved acceleration and therefore better results in the electroless deposition bath. After electroless copper plating, the panels were examined and found to be dark green in color with no effective copper coverage. A reducing agent actually provides worse results than the prior art acceleration bath, having the opposite effect of the oxidizing accelerator of this invention.

## Comparative Example C

FR-4 epoxy glass laminate panels are subjected to the procedure of Example 1 except that an accelerator bath in accordance with U.S. Patent 3,011,920 containing .5 Molar (50 ml./l.) $HClO_4$ was used instead of the accelerator of this invention. 11.8 microinches (299.7 nm) of copper was deposited in 6 minutes electroless deposition time. The panels were darker, had insufficient metal coverage and showed blistering in comparison to those of Example 1.

The preceding examples show that the oxidizing accelerator of this invention provides a better catalytic surface on the substrate to be plated than the prior art accelerator bath or the accelerator bath containing a reducing agent and therefore, improved plating rates on electroless deposition for a variety of substrates and electroless deposition baths and methods.

## Claims

1. A method of preparing a substrate for electroless deposition of metal thereon which comprises treating the substrate with a composition containing a mixed palladium-tin catalyst, and contacting said treated substrate with an accelerator bath containing an agent for oxidizing said tin from $Sn^{+2}$ to $Sn^{+4}$ characterised in that the accelerator bath is of alkaline pH.

2. A method according to claim 1 wherein said oxidizing agent is selected from sodium chlorite, sodium dichloroisocyanurate, sodium hypochlorite, sodium chlorate, potassium permanganate, sodium perborate and mixtures thereof.

3. A method according to claim 1 wherein said accelerator bath comprises a concentration of the oxidizing agent from 1 gram per liter up to saturation level.

4. A method according to any preceding claim wherein the pH of the accelerator bath is in the range from 8.3 to 9.5.

5. A method of electroless deposition of a metal on a non-conductive substrate, wherein prior to the deposition the substrate is prepared by a method according to any preceding claim.

## Patentansprüche

1. Verfahren zum Vorbereiten eines Substrates für elektrofreie Niederschlagung von Metall darauf, welches das Behandeln des Substrates mit einer Zusammensetzung, die einen gemischten Palladium-Zinn-Katalysator enthält, und das Inberührung bringen des behandelten Substrates mit einem Beschleunigerbad, das ein Mittel zum Oxidieren des Zinns von $Sn^{+2}$ nach $Sn^{+4}$ enthält, umfaßt, dadurch gekennzeichnet, daß das Beschleunigerbad einen alkalischen pH-Wert aufweist.

2. Verfahren nach Anspruch 1, dadurch gekennzeichnet, daß das Oxidierungsmittel ausgewählt ist aus Natriumchlorit, Natriumdichlorisocyanurat, Natriumhypochlorit, Natriumchlorat, Kaliumpermanganat, Natriumperborat und deren Gemischen.

3. Verfahren nach Anspruch 1, dadurch gekennzeichnet, daß das Beschleunigerbad eine Konzentration des Oxidierungsmittels von einem Gramm pro Liter bis zum Sättigungspegel aufweist.

4. Verfahren nach einem der vorangehenden Ansprüche, dadurch gekennzeichnet, daß der pH-Wert des Beschleunigerbades in dem Bereich von 8,3 bis 9,5 liegt.

5. Verfahren zur elektrofreien Niederschlagung eines Metalls auf einem nichtleitenden Substrat, dadurch gekennzeichnet, daß das Substrat vor der Niederschlagung durch ein Verfahren nach einem der vorangehenden Ansprüche vorbereitet wird.

## Revendications

1. Procédé de préparation d'un substrat, pour y appliquer un métal par dépôt autocatalytique, qui consiste à traiter le substrat avec une composition contenant un catalyseur mixte au palladium-étain, et à mettre en contact ledit substrat traité avec un bain accélérateur contenant un agent destiné à oxyder ledit étain du $Sn^{2+}$ au $Sn^{4+}$, caractérisé en ce que le bain accélérateur a un pH alcalin.

2. Procédé selon la revendication 1, dans lequel ledit agent oxydant est choisi entre le chlorite de sodium, le dichloroisocyanate de sodium, l'hypochlorite de sodium, le chlorate de sodium, le permanganate de potassium, le perborate de sodium et leurs mélanges.

3. Procédé selon la revendication 1, dans lequel ledit bain accélérateur contient l'agent oxydant à une concentration comprise entre 1 gramme par litre et la concentration à la saturation.

4. Procédé selon l'une quelconque des revendications précédentes, dans lequel le pH du bain accélérateur est compris dans l'intervalle de 8,3 à 9,5.

5. Procédé de dépôt autocatalytique d'un métal sur un substrat non-conducteur, dans lequel, avant le dépôt, le substrat est préparé par un procédé selon l'une quelconque des revendications précédentes.

6